# EUROPÄISCHE PATENTSCHRIFT

(11) **EP 0 852 815 B1**
(45) Veröffentlichungstag und Bekanntmachung des Hinweises auf die Patenterteilung: **19.07.2000**
(21) Anmeldenummer: 96939809.8
(22) Anmeldetag: 13.09.1996
(51) Int. Cl.: H01L 31/0203, H01L 33/00

(54) **Verfahren zur Herstellung eines optoelektronischen Halbleiter-Bauelements**
Process of manufacturing an optoelectronic semiconductor device
Procédé de fabrication d'un composant semiconducteur optoelectronique

(30) Priorität: 26.09.1995 DE 19535777
(43) Veröffentlichungstag der Anmeldung: 15.07.1998
(73) Patentinhaber: SIEMENS AKTIENGESELLSCHAFT, 80333 München (DE)
(72) Erfinder: BRUNNER, Herbert, D-93047 Regensburg (DE); HAAS, Heinz, D-93059 Regensburg (DE); WAITL, Günther, D-93049 Regensburg (DE)
(86) Internationale Anmeldenummer: DE9601728
(87) Internationale Veröffentlichungsnummer: WO9712404

(56) Entgegenhaltungen:
- DE-A- 4 232 644
- DE-U- 9 202 608
- PATENT ABSTRACTS OF JAPAN vol. 011, no. 312 (E-548), 12.Oktober 1987 & JP 62 105486 A (HIKARI DENSHI KOGYO KENKYUSHO:KK), 15.Mai 1987,
- PATENT ABSTRACTS OF JAPAN vol. 011, no. 367 (E-561), 28.November 1987 & JP 62 139367 A (OKI ELECTRIC IND CO LTD;OTHERS: 01), 23.Juni 1987,
- PATENT ABSTRACTS OF JAPAN vol. 016, no. 055 (E-1165), 12.Februar 1992 & JP 03 254162 A (MITSUI PETROCHEM IND LTD), 13.November 1991,

## Beschreibung

Die Erfindung bezieht sich auf ein Verfahren zur Herstellung eines optoelektronischen Halbleiter-Bauelementes, insbesondere für Anwendungen mit sehr engen Abstrahl- bzw. Empfangscharakteristiken, bestehend aus einem eine annähernd ebene Chipträgerfläche aufweisenden Chipträger, auf welcher ein optoelektronischer Halbleiterchip mit vorbestimmter Ausrichtung seiner optischen Achse befestigt ist, und einem dem Chipträger zugeordneten und diesen abstützenden Sockelteil, welches aus einem Kunststoffmaterial gefertigt ist, wobei der Halbleiterchip elektrisch leitend mit wenigstens zwei durch das Sockelteil hindurchgeführten Elektrodenanschlüssen verbunden ist, und dem Halbleiterchip eine das Sockelteil übergreifende Linse zugeordnet ist.

Die bisherigen optoelektronischen Halbleiter-Bauelemente, insbesondere solche mit höheren Anforderungen an die optischen Eigenschaften wurden im wesentlichen in Metall-Glas-Gehäusen gefertigt. Hierbei wurden als Chipträger insbesondere aus Metall gefertigte Bodenplatten eingesetzt, die mit einer Metallkappe mit eingepaßter Glaslinse montiert wurden. Durch diese Montage vermittels einem Metallgehäuse konnte zum einen ein hermetisch dichter Abschluß des Gehäuses gewährleistet werden, und zum anderen eine Eignung des optoelektronischen Halbleiter-Bauelementes für bestimmte Hochtemperaturanwendungen ab etwa 150° Celsius zur Verfügung gestellt werden. Die Alterung des Halbleiterchips bei einer solchen Montageart war gering, da aufgrund des verwendeten Gehäusetyps aus Metall im wesentlichen keine Belastung auf den Halbleiterchip aufgrund von unmittelbar umgebendem Material vorlag. Schließlich konnten die optischen Eigenschaften des Halbleiter-Bauelementes aufgrund der in der Metallkappe eingefaßten Glaslinse günstig gestaltet werden. Als wesentlicher Nachteil der bisher hergestellten optoelektronischen Halbleiter-Bauelemente werden die aufgrund der relativ komplizierten Herstellung notwendigerweise einhergehenden erheblichen Kosten angesehen. Hierbei schlägt insbesondere die einen hohen Herstellungsaufwand erfordernde Metallkappe mit eingepaßter Glaslinse zu Buche. Fernerhin besitzen die in Metall-Glas-Gehäusen montierten Halbleiter-Bauelemente aufgrund der relativ groß zu veranschlagenden Justage- und Fertigungstoleranzen Probleme, so daß solche optoelektronischen Halbleiter-Bauelemente in der Regel ungünstigere Schielwinkel besitzen, d.h. fertigungsbedingte Abweichungen der optischen von der mechanischen Achse des Bauelements, so daß solche Halbleiter-Bauelemente bei Applikationen, bei denen es auf enge Abstrahl- bzw. Empfangscharakteristiken ankommt, nur bedingt einsetzbar sind. Bei den vorbekannten optoelektronischen Halbleiter-Bauelementen wirkt sich somit bei engeren Toleranzvorgaben ein größeres Justagespiel bei der Montage äußerst ungünstig auf den erzielten Schielwinkel aus.

Darüber hinaus sind in Massenstückzahlen gefertigte Kunststoff-Leuchtdioden mit geringeren Anforderungen an die optischen Qualitäten bekannt, bei denen das Gehäuse bestehend aus Bodenplatte und Kappe in einem Verfahrensgang gegossen und somit einteilig hergestellt werden. Dies stellt an sich eine gegenüber Metall-Glas-Gehäusen wesentlich kostengünstigere Herstellungsart dar. Durch den einen Arbeitsgang der (drucklosen) Gußherstellung ergeben sich jedoch zu hohe Justagetoleranzen und damit hohe Schielwinkel, so daß solchermaßen hergestellte optoelektronischen Halbleiterbauelemente für spezielle Anwendungen lediglich ungenügende optische Eigenschaften besitzen.

Aus der Patent Abstracts of Japan, Band 016 Nr. 055 (E-1165), 12.2.92 & JP-A-03254162 ist eine Leuchtdiode mit einem Sokkelteil aus Metall und einer Kunststoffkappe mit Linsenteil bekannt geworden. Bei dieser Anordnung soll die Genauigkeit der Positionierung verbessern und die Emissionsrate gesteigert sein.

Die Patent Abstracts of Japan, Band 011 Nr. 367 (E-561), 28.11.87 & JP-A-62139367 und Patent Abstracts of Japan, Band 011 Nr. 312 (E-548), 12.10.87 & JP-A-62105486 zeigen weitere Leuchtdioden mit separat gestalteten Linsenkappen.

Der Erfindung liegt die Aufgabe zugrunde, ein Verfahren zur Herstellung eines optoelektronischen Halbleiter-Bauelementes zur Verfügung zu stellen, welches Bauelement bei hohen Anforderungen an die Justagetoleranzen und damit Schielwinkel erheblich kostengünstiger hergestellt werden kann.

Diese Aufgabe wird durch ein Verfahren zur Herstellung eines optoelektronischen Halbleiter-Bauelementes nach Anspruch 1 gelöst.

Hierbei kann vorgesehen sein, daß die eigenständig gestaltete und aus Kunststoffmaterial gefertigte Kappe als separates Bauteil durch einen Spritzgußvorgang hergestellt wird. Die Herstellung des Sockelteiles wird vorzugsweise durch einen Spritzgußvorgang eines Chipträgers aus einer Vielzahl von in einem Chipträgerband aufeinanderfolgend angeordneter Chipträger durchgeführt. Die Trennung eines optoelektronischen Halbleiter-Bauelementes von einem Chipträgerband erfolgt erst nach erfolgter Herstellung des Sockelteiles, Befestigung des Halbleiterchips auf der Chipträgerfläche durch Bonden, sowie Kontaktierung des Halbleiterchips mit den Elektrodenanschlüssen. Das umspritzte Trägerband kann endlos hergestellt und verarbeitet werden, sogenannte Reel-to-reel-Technik. Auf diese Weise kann insgesamt eine kostengünstige Montage des Bauelementes mit sehr engen elektrooptischen Parametertoleranzen verwirklicht werden.

Von Vorteil ist vorgesehen, daß die das Sockelteil übergreifende Linse als Teil einer eigenständig gestalteten und aus Kunststoffmaterial gefertigten Kappe ausgebildet ist, wobei die Kappe ein Haltemittel für eine formschlüssig mechanische Verbindung mit einem Stützmittel des Sockelteiles aufweist, derart, daß beim Aufsetzen der Kappe auf das Sockelteil das Haltemittel und das Stützmittel wechselweise miteinander in Eingriff gelangen, und das Haltemittel und das Stützmittel derart gestaltet sind, daß beim Aufsetzen der Kappe auf das Sockelteil diese selbsttätig so zueinander positioniert werden, daß die optischen Achsen der Linse und des auf dem Chipträger angeordneten Halbleiterchips wenigstens annähernd zusammenfallen.

Dadurch, daß das den Chipträger abstützende Sockelteil und die auf den Sockelteil aufgesetzte Kappe mit der integriert ausgebildeten Linse als zwei separate, vermittels jeweils einem Spritzgußvorgang hergestellte Kunststoff-Bauteile gefertigt werden, kann ein optoelektronisches Halbleiter-Bauelement im Vergleich zu den vorbekannten Bauelementen wesentlich kostengünstiger, und zwar etwa um den Faktor 10 kostengünstiger hergestellt werden, ohne Einbußen in den optischen Eigenschaften des Halbleiter-Bauelementes hinzunehmen. Die beiden separat gefertigten Bauteile können annähernd spielfrei selbsttätig zueinander gefügt werden, so daß das erfindungsgemäße Halbleiter-Bauelement lediglich geringste Justagetoleranzen und damit geringste Schielwinkel besitzt. Das erfindungsgemäße optoelektronische Halbleiter-Bauelement eignet sich daher hervorragend für Anwendungen mit sehr engen Abstrahl- bzw. Empfangscharakteristiken. Die Herstellung der in der Kappe integrierten Linse aus Kunststoff ermöglicht darüber hinaus im Gegensatz zu Glaslinsen wesentlich genauer herstellbare Linsenformen und daher bessere optische Eigenschaften der Linse. Durch eine geeignete Gestaltung von Kappe und Sockelteil kann erreicht werden, daß beim Aufsetzen der Kappe auf das Sockelteil diese selbsttätig zueinander positioniert bzw. zentriert werden.

In Weiterbildung der Erfindung ist vorgesehen, daß Kappe und Sockelteil eine im wesentlichen zylindersymmetrische Querschnittsform aufweisen, deren Symmetrieachsen zueinander konzentrisch verlaufen und jeweils mit den optischen Achsen von Linse und Halbleiterchip zusammenfallen. Hierbei ist von Vorteil vorgesehen, daß das Haltemittel der Kappe und das Stützmittel des Sockelteiles für eine formschlüssige Verbindung angepaßt bzw. ausgebildet sind. Bei einer konkreten Ausgestaltung der Erfindung kann vorgesehen sein, daß das Haltemittel und das Stützmittel so ausgebildet sind, daß beim Fügen von Kappe und Sockelteil diese selbsttätig so zueinander positioniert werden, daß eine stabile, wenigstens annähernd spielfreie Symmetrielage von Kappe und Sockelteil gewährleistet ist.

Zur Unterstützung der mechanischen Ausrichtung von Kappe und Sockelteil kann vorgesehen sein, daß das Stützmittel des Sokkelteiles an seinem Außenumfang eine umlaufende und das Haltemittel der Kappe abstützende Wiederlagerfläche besitzt.

Hierbei kann vorgesehen sein, daß die der in axialer Richtung lösbaren, formschlüssig mechanischen Verbindung von Kappe und Sockelteil zugeordneten Halte- und Stützmittel durch an beiden Teilen umlaufend und wechselweise ausgebildete Vorsprünge und Nutausnehmungen gebildet sind, oder daß die für eine gegenseitige Ausrichtung von Kappe und Sockelteil in Umfangsrichtung vorgesehenen Halte- und Stützmittel durch zusätzliche, an beiden Teilen wechselweise angeordnete radiale und in Umfangsrichtung begrenzt ausgebildete Vorsprünge und Ausnehmungen gebildet sind.

Zur selbsttätigen Festlegung der Befestigung von Kappe und Sockelteil kann vorgesehen sein, daß das Haltemittel der Kappe mit einer federnden Auskragung versehen ist, die mit einer in dem Stützmittel des Sockelteiles vorgesehenen Raste zur selbsttätigen Festlegung der Kappe und des Sockelteiles in einer Montagelage zugeordnet ist.

Weiterhin kann zur weiteren Gestaltung der optischen Eigenschaften des Bauelementes oder lediglich zum Zwecke des Schutzes des Halbleiterchips vorgesehen sein, daß der Halbleiterchip mit einer Linsenabdeckung bzw. linsenförmigen Chipabdeckung übergriffen ist, welche zwischen dem Sockelteil und der Kappe angeordnet bzw. befestigt ist, wobei die den Halbleiterchip übergreifende Linsenabdeckung aus einem lichtdurchlässigen Kunststoffmaterial gefertigt ist, welches insbesondere ein optisches Filtermaterial aufweist.

Des weiteren kann das aus Kunststoff gefertigte Sockelteil ein Material zur Erhöhung der Absorption von einfallendem Streulicht aufweisen, welches insbesondere mit schwarzer Farbe eingefärbt ist. Die Formgebung des aus Kunststoff gefertigten Sockelteiles kann so gewählt werden, daß neben der Eignung zur Befestigung der Kappe ein Reflektor um den Halbleiterchip ausgebildet wird und die optischen Eigenschaften des Bauelementes in günstiger Weise mit bestimmt werden. Ferner kann innerhalb des Sockelteiles ein dem Halbleiterchip zugeordneter Reflektor zur Verbesserung der Abstrahleigenschaften des Bauelementes vorgesehen sein.

Die Form der in der aus Kunststoff gefertigten Kappe integriert ausgebildeten Linse kann je nach gewünschten optischen Eigenschaften des Bauelementes auf einfache und kostengünstige Weise variabel gestaltet sein. So kann beispielsweise die Kappe eine integrierte Fresnellinse besitzen, so daß von Vorteil optoelektronische Bauelemente mit besonders geringer Bauhöhe und sehr engwinkligen Abstrahl- bzw. Empfangscharakteristiken verwirklicht werden können.

Insgesamt ermöglicht es die erfindungsgemäß hergestellte Anordnung, die Optik des Bauelementes sehr differenziert und genau zu gestalten.

Bei einer besonders bevorzugten Ausführung der Erfindung besteht das Material des Sockelteils aus einem hochtemperaturfesten, lötbeständigen Kunststoff, mit dem der Chipträger und die Lötanschlüsse bzw. Elektrodenanschlüsse umspritzt ist. Das Kunststoffmaterial kann hierbei insbesondere ein Thermoplast sein, wie beispielsweise LCP = Liquid Crystal Polymers, PPA = Polyphtalamid, oder Polysulfon oder dergleichen Material. Darüber hinaus sind als Kunststoffmaterial des Sockelteils auch Duroplastmaterialien möglich, die gegenüber Thermoplasten in der Regel kostenungünstiger sein werden und für Hochtemperaturanwendungen weniger geeignet sein dürften.

Das Material der Kappe, welche die Linse des Bauelementes integriert umfaßt, kann beispielsweise ein Polycarbonatmaterial sein, welches optisch klar und damit vollständig durchsichtig, oder zu Zwecken der Filterung von Licht bestimmter Wellenlänge eingefärbt oder mit bestimmten absorptiven Materialien versehen sein kann.

Das Material der den Halbleiterchip übergreifenden Linsenabdeckung bzw. linsenförmigen Chipabdeckung kann vorzugsweise Harz oder Silikon aufweisen.

Weitere Merkmale, Vorteile und Zweckmäßigkeiten der Erfindung ergeben sich aus der nachfolgenden Beschreibung von Ausführungsbeispielen anhand der Zeichnung. Es zeigt:
Fig. 1 eine schematische Schnittansicht eines optoelektronischen Halbleiter-Bauelementes hergestellt gemäß der Erfindung;
Fig. 2A eine schematische Schnittansicht eines Sockelteiles und eines Chipträgers bei einem optoelektronischen Halbleiter-Bauelement;
Fig. 2B eine schematische Draufsicht des in Fig. 2A dargestellten optoelektronischen Halbleiter-Bauelementes;
Fig. 3A eine schematische Schnittansicht einer Kappe mit integriert ausgebildeter Linse eines optoelektronischen Halbleiter-Bauelementes;
Fig. 3B eine schematische Schnittansicht eines Sockelteils;
Fig. 3C eine schematische Draufsicht des in Fig. 3B dargestellten Sockelteiles; und
Fig. 4 eine schematische Ansicht eines Chipträgerbandes zur Herstellung eines optoelektronischen Halbleiter-Bauelementes gemäß der Erfindung.

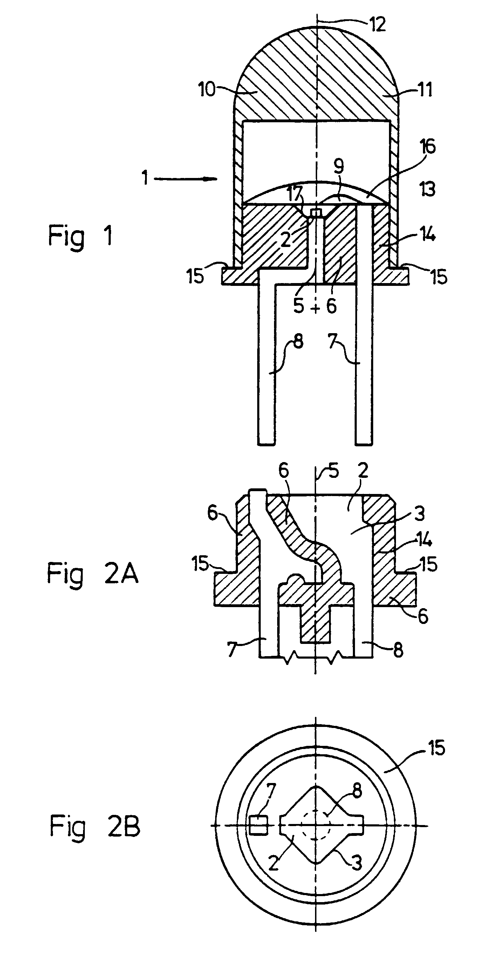

Die Figuren zeigen ein optoelektronisches Halbleiter-Bauelement 1 mit einem eine annähernd ebene Chipträgerfläche 2 aufweisenden Chipträger 3, auf welcher ein optoelektronischer Halbleiterchip 4 mit vorbestimmter Ausrichtung seiner optischen Achse 5 befestigt ist, und einem dem Chipträger 3 zugeordneten und diesen abstützenden Sockelteil 6, welches aus einem Kunststoffmaterial gefertigt ist. Der optoelektronische Halbleiterchip 4 ist elektrisch leitend mit zwei durch das Sockelteil 6 hindurchgeführten Elektrodenanschlüssen 7 und 8 verbunden, wobei in der Fig. 1 ein Kontaktdraht 9 die Verbindung des Halbleiterchips 4 mit dem einen Elektrodenanschluß 7 bewirkt, und die elektrische Verbindung mit dem anderen Elektrodenanschluß 8 durch Bondverbindung der elektrisch leitenden Unterseite des Halbleiterchips 4 mit der Chipträgerfläche 2, welche einstückig mit dem anderen Elektrodenanschluß 8 ausgebildet ist, bewerkstelligt ist. Die zur optischen Abbildung des Halbleiterchips 4 vorgesehene Linse 10 ist als Teil einer eigenständig gestalteten und vorzugsweise aus Polycarbonat gefertigten Kappe 11 ausgebildet, die so auf das Sokkelteil 6 aufgesetzt ist, daß die optische Achse 12 der Linse 10 mit der optischen Achse 5 des auf dem Chipträger 3 angebrachten Halbleiterchips 4 zusammenfällt. Hierzu besitzt die Kappe 11 ein Haltemittel 13 für eine formschlüssig mechanische Verbindung mit einem Stützmittel 14 des Sockelteils 6, derart, daß beim Aufsetzen der Kappe 11 auf das Sockelteil 6 das Haltemittel 13 und das Stützmittel 14 wechselweise miteinander in Eingriff gelangen. Kappe 11 und Sockelteil 6 besitzen eine im wesentlichen zylindersymmetrische Querschnittsform, deren Zylindersymmetrieachsen konzentrisch zueinander verlaufen und jeweils mit den optischen Achsen 5 und 12 von Linse 10 und Halbleiterchip 4 zusammenfallen. Der Innendurchmesser des Haltemittels 13 ist bei der in Fig. 1 dargestellten Ausführung wenigstens annähernd identisch mit dem Außendurchmesser des Stützmittels 14, so daß Haltemittel 13 und Stützmittel 14 für eine formflüssige Verbindung angepaßt und ausgebildet sind. Zur definierten Abstützung der Kappe 11 auf dem Sockelteil 6 besitzt das Stützmittel 14 des Sockelteiles 6 an seinem Außenumfang eine umlaufende und das Haltemittel 13 der Kappe 11 abstützende Wiederlagerfläche 15. Durch diese Ausbildung können beim Fügen von Kappe 11 und Sockelteil 6 diese selbsttätig so zueinander positioniert werden, daß eine stabile, annähernd spielfreie Symmetrielage von Kappe 11 und Sockelteil 6 gewährleistet ist, so daß das erfindungsgemäße optoelektronische Bauelement 1 geringste Justagetoleranzen und damit optische Schielwinkel besitzt, und somit insbesondere für Anwendungen mit sehr engen Abstrahl- bzw. Empfangscharakteristiken geeignet ist.

Der Halbleiterchip 4 ist mit einer aus Harz oder Silikon bestehenden Schutz- bzw. Linsenabdeckung 16 übergriffen, welche zwischen dem Sockelteil 6 und der Kappe 11 befestigt ist.

Ein in dem Sockelteil 6 ausgebildeter Reflektor, der dem Halbleiterchip 4 zugeordnet ist und die Abstrahlcharakteristik bzw. Empfangscharakteristik mitbestimmt, ist mit dem Bezugszeichen 17 angedeutet.

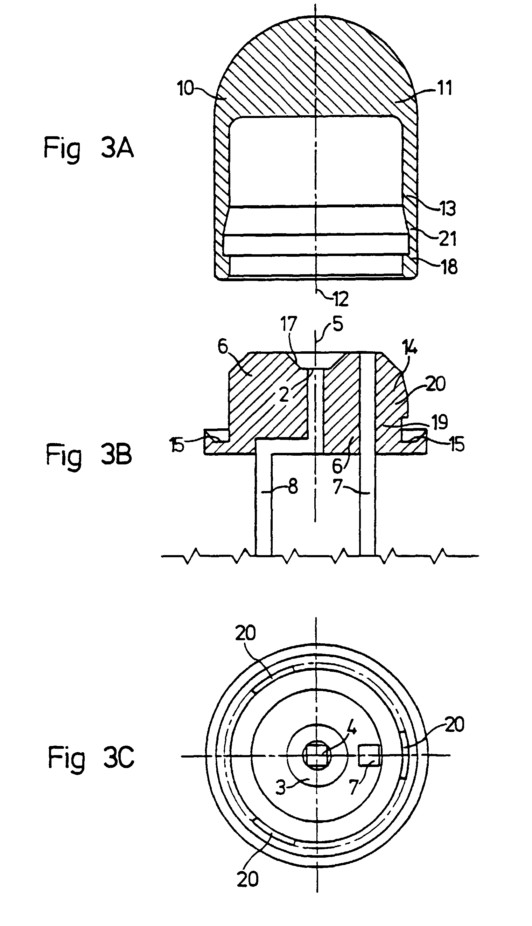

Bei dem in Fig. 1 dargestellten Ausführungsbeispiel der Erfindung kann die dauerhafte stabile Befestigung der auf das Sockelteil 6 aufgesetzten Kappe 11 durch eine Klebeverbindung oder Schweißverbindung erfolgen. Demgegenüber zeigen die Fig. 3A bis 3C ein weiteres Ausführungsbeispiel eines erfindungsgemäßen optoelektronischen Bauelementes, bei dem nach dem Aufsetzen der Kappe 11 auf das Sockelteil 6 eine selbsttätige Festlegung einer dauerhaften und sicheren Befestigung durch einen Schnappverschluß erfolgen kann. Hierzu ist das Haltemittel 13 der Kappe 11 mit einer federnden Auskragung 18 versehen, die mit einer in dem Stützmittel 14 des Sockelteiles 6 vorgesehenen Raste 19 zur selbsttätigen Festlegung der Kappe 11 und des Sockelteils 6 in einer montierten Lage zusammenwirkt.

Weiterhin sind bei dem Ausführungsbeispiel nach den Fig. 3A bis 3C Maßnahmen ersichtlich, die eine zuverlässige selbsttätige Positionierung beim Zusammenfügen von Kappe 11 und Sokkelteil 6 unterstützen. Beispielsweise sind die der in axialer Richtung lösbaren, formschlüssig mechanischen Verbindung von Kappe 11 und Sockelteil 6 durch an beiden Teilen von Haltemittel 13 und Stützmittel 14 umlaufend oder in Umfangsrichtung begrenzt und wechselweise ausgebildete Vorsprünge 20 und Vertiefungen 21 vorgesehen.

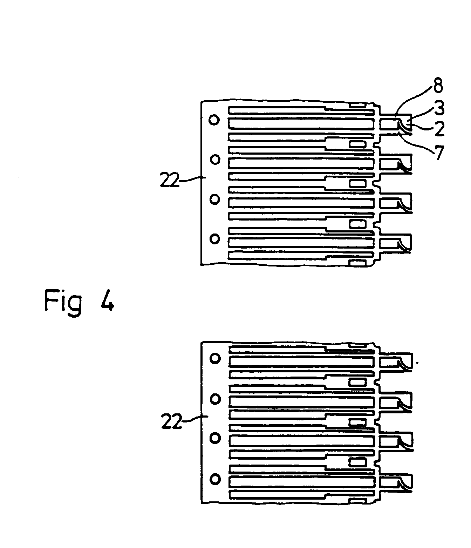

Im folgenden wird das erfindungsgemäße Verfahren zur Herstellung eines optoelektronischen Halbleiter-Bauelementes 1 gemäß einem bevorzugten Ausführungsbeispiel näher erläutert. Die Fertigung geht aus von einem gemäß Fig. 4 dargestellten Chipträgerband 22, welches endlos hergestellt und verarbeitet werden kann (Reel-to-reel-Technik). Zunächst werden in einem Prägeschritt zur Herstellung glatter und sauberer Oberflächen die Chipträgerflächen 2 gefertigt, auf welche die Halbleiterchips 4 befestigt werden sollen. Daran anschließend werden die Bereiche der Chipträger 3 und Elektrodenanschlüsse 7 und 8 einem Galvanikarbeitsgang unterzogen, bei dem beispielsweise zunächst Nickel, und anschließend Silber aufgetragen werden. Sodann wird als nächster Herstellungsschritt das Sockelteil 6 durch Umspritzen des Chipträgers 3 und der Elektrodenanschlüsse 7 und 8 mit einem Thermoplastmaterial gefertigt. Hierbei wird das Thermoplastmaterial zur Vermeidung von Lunker- und Einschlußbildung unter Druck in eine Spritzgußform eingebracht, welche die gewünschte vorbestimmte Gestaltung des Sockelteils besitzt. Daran anschließend wird der Halbleiterchip 4 auf der Chipträgerfläche 2 durch Bonden, insbesondere Kleben, befestigt. Gegebenenfalls werden Bonddrähte zur Kontaktierung des Halbleiterchips 4 mit einem Elektrodenanschluß verbunden. Nach diesem Herstellungsschritt kann, immer noch am endlosen Chipträgerband 22, zum Schutz oder zur Gestaltung der Optik eine den Halbleiterchip 4 übergreifende Linsenabdeckung 16 durch Spritzgießen eines geeigneten lichtdurchlässigen oder mit einem Filtermaterial versehenen Kunststoffmaterials hergestellt werden. Daran anschließend wird, nachdem die einzelnen Chipträger 3 mit ausgebildetem Sockelteil 6 und aufgebrachter Chipabdeckung 16 von dem Chipträgerband 22 getrennt wurden, die als eigenständig gestaltete und aus Polycarbonat gefertigte Kappe 11 mit integrierter Linse 10 auf das Sockelteil 6 derart aufgesetzt, daß Kappe 11 und Sockelteil 6 selbsttätig so zueinander positioniert werden, daß die optischen Achsen 5 und 12 zusammenfallen.

## Patentansprüche

1. Verfahren zur Herstellung eines optoelektronischen Halbleiter-Bauelementes (1), insbesondere für Anwendungen mit sehr engen Abstrahl- bzw. Empfangscharakteristiken, mit einem eine annähernd ebene Chipträgerfläche (2) aufweisenden Chipträger (3), auf welcher ein optoelektronischer Halbleiterchip (4) mit vorbestimmter Ausrichtung seiner optischen Achse (5) befestigt ist, und einem dem Chipträger (3) zugeordneten und diesen abstützenden Sockelteil (6), welches aus einem Kunststoffmaterial gefertigt ist, wobei der Halbleiterchip (4) elektrisch leitend mit wenigstens zwei durch das Sockelteil (6) hindurchgeführten Elektrodenanschlüssen (7, 8) verbunden ist, und dem Halbleiterchip (4) eine das Sockelteil (6) übergreifende Linse (10) zugeordnet ist, wobei das Herstellungsverfahren die in nachstehender Reihenfolge angegebenen Schritte aufweist:
- Fertigen des den Chipträger (3) und die wenigstens zwei Elektrodenanschlüsse (7, 8) umgebenden und diese abstützenden Sockelteiles (6) durch einen Spritzgußvorgang an einem Chipträgerband (22), das eine Vielzahl von aufeinanderfolgend angeordneten Chipträgern (3) aufweist,
- Befestigen des optoelektronischen Halbleiterchips (4) auf der annähernd ebenen Chipträgerfläche (2) des Chipträgers (3),
- Kontaktieren des optoelektronischen Halbleiterchips (4) mit den wenigstens zwei durch das Sockelteil (6) hindurchgeführten Elektrodenanschlüssen (7, 8),
- Aufsetzen einer eigenständig gestalteten und aus Kunststoffmaterial gefertigten Kappe (11), welche die das Sockelteil (6) übergreifende Linse (10) aufweist, auf das Sockelteil (6) derart, daß Kappe (11) und Sockelteil (6) selbsttätig so zueinander positioniert werden, daß die optischen Achsen (5, 12) der Linse (10) und des auf dem Chipträger (3) angeordneten Halbleiterchips (4) wenigstens annähernd zusammenfallen, und
- dauerhaftes Befestigen der Kappe (11) mit dem Sockelteil (6).

2. Verfahren nach Anspruch 1, dadurch gekennzeichnet, daß die eigenständig gestaltete und aus Kunststoffmaterial gefertigte Kappe (11) als separates Bauteil durch einen Spritzgußvorgang hergestellt wird.

3. Verfahren nach Anspruch 1 oder 2, dadurch gekennzeichnet, daß zwischen dem Sockelteil (6) und der Kappe (11) eine den Halbleiterchip (4) übergreifende Linsenabdeckung (16) hergestellt wird.

4. Verfahren nach einem der Ansprüche 1 bis 3, dadurch gekennzeichnet, daß die Trennung eines einzelnen optoelektronischen Halbleiter-Bauelementes (1) von dem Chipträgerband (22) erst nach erfolgter Herstellung des Sockelteiles (6), Befestigung des Halbleiterchips (4) auf der Chipträgerfläche (2) durch Bonden, sowie Kontaktierung des Halbleiterchips (4) mit den Elektrodenanschlüssen (7, 8) erfolgt.

5. Verfahren nach einem der Ansprüche 1 bis 4, dadurch gekennzeichnet, daß die Kappe (11) ein Haltemittel (13) für eine formschlüssig mechanische Verbindung mit einem Stützmittel (14) des Sockelteiles (6) aufweist, derart, daß beim Aufsetzen der Kappe (11) auf das Sockelteil (6) das Haltemittel (13) und das Stützmittel (14) wechselweise miteinander in Eingriff gelangen, und das Haltemittel (13) und das Stützmittel (14) derart gestaltet sind, daß beim Aufsetzen der Kappe (11) auf das Sockelteil (6) diese selbsttätig so zueinander positioniert werden, daß die optischen Achsen (12) der Linse (10) und des auf dem Chipträger (3) angeordneten Halbleiterchips (4) wenigstens annähernd zusammenfallen.

6. Verfahren nach Anspruch 5, dadurch gekennzeichnet, daß Kappe (11) und Sockelteil (6) eine im wesentlichen zylindersymmetrische Querschnittsform aufweisen, deren Symmetrieachsen zueinander konzentrisch verlaufen und jeweils mit den optischen Achsen (5, 12) von Linse (10) und Halbleiterchip (4) zusammenfallen.

7. Verfahren nach Anspruch 5 oder 6, dadurch gekennzeichnet, daß das Haltemittel (13) der Kappe (11) und das Stützmittel (14) des Sockelteiles (6) für eine formschlüssige Verbindung angepaßt bzw. ausgebildet sind.

8. Verfahren nach einem der Ansprüche 5 bis 7, dadurch gekennzeichnet, daß das Haltemittel (13) und das Stützmittel (14) so ausgebildet werden, daß beim Fügen von Kappe (11) und Sockelteil (6) diese selbsttätig so zueinander positioniert werden, daß eine stabile, wenigstens annähernd spielfreie Symmetrielage von Kappe (11) und Sockelteil (6) gewährleistet ist.

9. Verfahren nach einem der Ansprüche 5 bis 8, dadurch gekennzeichnet, daß das Stützmittel (14) des Sockelteiles (6) an seinem Außenumfang eine umlaufende und das Haltemittel (13) der Kappe (11) abstützende Wiederlagerfläche (15) besitzt.

10. Verfahren nach einem der Ansprüche 5 bis 9, dadurch gekennzeichnet, daß die der in axialer Richtung lösbaren, formschlüssig mechanischen Verbindung von Kappe (11) und Sockelteil (6) zugeordneten Halte- (13) und Stützmittel (14) durch an beiden Teilen umlaufend und wechselweise ausgebildete Vorsprünge (20) und Nutausnehmungen (21) gebildet werden.

11. Verfahren nach einem der Ansprüche 5 bis 10, dadurch gekennzeichnet, daß die für eine gegenseitige Ausrichtung von Kappe (11) und Sockelteil (6) in Umfangsrichtung vorgesehenen Halte- (13) und Stützmittel (14) durch zusätzliche, an beiden Teilen wechselweise angeordnete radiale und in Umfangsrichtung begrenzt ausgebildete Vorsprünge (20) und Ausnehmungen (21) gebildet werden.

12. Verfahren nach einem der Ansprüche 5 bis 11, dadurch gekennzeichnet, daß das Haltemittel (13) der Kappe (11) mit einer federnden Auskragung (18) versehen wird, die mit einer in dem Stützmittel (14) des Sockelteiles (6) vorgesehenen Raste (19) zur selbsttätigen Festlegung der Kappe (11) und des Sokkelteiles (6) in einer Montagelage zugeordnet ist.

13. Verfahren nach einem der Ansprüche 1 bis 12, dadurch gekennzeichnet, daß das Sockelteil (6) aus einem Hochtemperaturkunststoff hergestellt wird.

14. Verfahren nach einem der Ansprüche 1 bis 13, dadurch gekennzeichnet, daß das Sockelteil (6) aus einem thermoplastischen Kunststoff, insbesondere aus Liquid Crystal Polymers, oder Polyphtalamid, oder Polysulfon hergestellt wird.

15. Verfahren nach Anspruch 3, dadurch gekennzeichnet, daß die den Halbleiterchip (4) übergreifende Linsenabdeckung (16) aus einem lichtdurchlässigen Kunststoffmaterial gefertigt wird, welches insbesondere ein optisches Filtermaterial aufweist.

16. Verfahren nach einem der Ansprüche 1 bis 15, dadurch gekennzeichnet, daß das aus Kunststoff gefertigte Sockelteil (6) ein Material zur Erhöhung der Absorption von einfallendem Streulicht aufweist, und insbesondere mit schwarzer Farbe eingefärbt ist.

17. Verfahren nach einem der Ansprüche 1 bis 16, dadurch gekennzeichnet, daß innerhalb des Sockelteiles (6) ein dem Halbleiterchip (4) zugeordneter Reflektor (17) vorgesehen wird.

## Claims

1. Method for producing an optoelectronic semiconductor component (1), in particular for applications having very narrow radiation and/or reception characteristics, having a chip carrier (3), which has an approximately planar chip carrier surface (2) and on which an optoelectronic semiconductor chip (4) is fastened with predetermined alignment of its optical axis (5), and a base part (6), which is assigned to the chip carrier (3), supports the latter and is produced from a plastic material, the semiconductor chip (4) being electrically conductively connected to at least two electrode terminals (7, 8) routed through the base part (6), and the semiconductor chip (4) being assigned a lens (10), which engages over the base part (6), the production method having the steps specified in the order below:
- production of the base part (6) which surrounds the chip carrier (3) and the at least two electrode terminals (7, 8) and supports these, by means of an injection-moulding operation, on a chip carrier strip (22) having a multiplicity of successively arranged chip carriers (3),
- fastening of the optoelectronic semiconductor chip (4) on the approximately planar chip carrier surface (2) of the chip carrier (3),
- contact-making of the optoelectronic semiconductor chip (4) with the at least two electrode terminals (7, 8) routed through the base part (6),
- emplacement of an independently configured cap (11), which is produced from plastic material and has the lens (10) engaging over the base part (6), onto the base part (6) in such a way that the cap (11) and the base part (6) are automatically positioned with respect to one another in such a way that the optical axes (5, 12) of the lens (10) and of the semiconductor chip (4) arranged on the chip carrier (3) coincide at least approximately, and
- permanent fastening of the cap (11) to the base part (6).

2. Method according to Claim 1, characterized in that the independently configured cap (11) produced from plastic material is produced as a separate structural part by means of an injection-moulding operation.

3. Method according to Claim 1 or 2, characterized in that a lens covering (16), which engages over the semiconductor chip (4), is produced between the base part (6) and the cap (11).

4. Method according to one of Claims 1 to 3, characterized in that an individual optoelectronic semiconductor component (1) is separated from the chip carrier strip (22) only after the production of the base part (6), fastening of the semiconductor chip (4) on the chip carrier surface (2) by means of bonding, as well as the contact-making of the semiconductor chip (4) with the electrode terminals (7, 8).

5. Method according to one of Claims 1 to 4, characterized in that the cap (11) has a holding means (13) for a positively locking mechanical connection to a supporting means (14) of the base part (6), in such a way that when the cap (11) is placed onto the base part (6), the holding means (13) and the supporting means (14) alternately engage with one another, and the holding means (13) and the supporting means (14) are configured in such a way that when the cap (11) is placed onto the base part (6), these are automatically positioned with respect to one another in such a way that the optical axes (12) of the lens (10) and of the semiconductor chip (4) arranged on the chip carrier (3) coincide at least approximately.

6. Method according to Claim 5, characterized in that the cap (11) and the base part (6) have an essentially cylindrically symmetrical cross-sectional shape whose axes of symmetry run concentrically with respect to one another and each coincide with the optical axes (5, 12) of lens (10) and semiconductor chip (4).

7. Method according to Claim 5 or 6, characterized in that the holding means (13) of the cap (11) and the supporting means (14) of the base part (6) are adapted and/or designed for a positively locking connection.

8. Method according to one of Claims 5 to 7, characterized in that the holding means (13) and the supporting means (14) are designed in such a way that when the cap (11) and the base part (6) are joined, these are automatically positioned with respect to one another in such a way as to ensure a stable, at least approximately play-free symmetry position of cap (11) and base part (6).

9. Method according to one of Claims 5 to 8, characterized in that the supporting means (14) of the base part (6) has, on its outer circumference, a peripheral abutment surface (15), which supports the holding means (13) of the cap (11).

10. Method according to one of Claims 5 to 9, characterized in that the holding means (13) and supporting means (14) which are assigned to the positively locking mechanical connection of cap (11) and base part (6), which connection can be released in the axial direction, are formed by projections (20) and grooved recesses (21) which are formed alternately and peripherally on both parts.

11. Method according to one of Claims 5 to 10, characterized in that the holding means (13) and supporting means (14) which are provided for mutual alignment of cap (11) and base part (6) in the circumferential direction are formed by additional, radial projections (20) and recesses (21) which are arranged alternately on both parts and are formed to a limited extent in the circumferential direction.

12. Method according to one of Claims 5 to 11, characterized in that the holding means (13) of the cap (11) is provided with a resilient protrusion (18), which is assigned with a notch (19), provided in the supporting means (14) of the base part (6), for the automatic establishment of the cap (11) and of the base part (6) in a mounting position.

13. Method according to one of Claims 1 to 12, characterized in that the base part (6) is produced from a high-temperature plastic.

14. Method according to one of Claims 1 to 13, characterized in that the base part (6) is produced from a thermoplastic, in particular from liquid crystal polymers, or polyphthalamide, or polysulphone.

15. Method according to Claim 3, characterized in that the lens covering (16) engaging over the semiconductor chip (4) is produced from a light-transmitting plastic material which, in particular, has an optical filter material.

16. Method according to one of Claims 1 to 15, characterized in that the base part (6) produced from plastic has a material for increasing the absorption of incident scattered light, and, in particular, is coloured with a black colouring substance.

17. Method according to one of Claims 1 to 16, characterized in that a reflector (17) assigned to the semiconductor chip (4) is provided inside the base part (6).

## Revendications

1. Procédé de fabrication d'un composant semi-conducteur optoélectronique (1), destiné notamment à des applications présentant des caractéristiques d'émission, resp. de réception très étroites, comprenant un porteur de puce (3) comportant une surface porteuse de puces (2) quasiment plane, sur laquelle une puce semi-conductrice optoélectronique (4) à orientation prédéterminée de son axe optique (5) est fixée, et une partie socle (6) associée au porteur de puce (3) et soutenant celui-ci, laquelle est fabriquée en une matière plastique, la puce semi-conductrice (4) étant reliée de manière électroconductrice à au moins deux raccords d'électrodes (7, 8) traversant la partie socle (6), et une lentille (10) recouvrant la partie socle (6) étant associée à la puce semi-conductrice (4), le procédé de fabrication présentant les étapes indiquées dans l'ordre ci-après:
- Fabrication de la partie socle (6) entourant le porteur de puce (3) et les au moins deux raccords d'électrode (7, 8) et soutenant ceux-ci, par une opération de moulage par injection sur une bande porteuse de puces (22), qui présente une pluralité de porteurs de puces (3) disposés l'un après l'autre,
- Fixation de la puce semi-conductrice optoélectronique (4) sur la surface porteuse de puces (2) quasiment plane du porteur de puce (3),
- Mise en contact de la puce semi-conductrice optoélectronique (4) avec les au moins deux raccords à électrode (7, 8) traversant la partie socle (6),
- Pose d'un capuchon (11) formé de manière autonome et fabriqué en matière plastique, lequel présente la lentille (10) recouvrant la partie socle (6), sur la partie socle (6) de telle façon que le capuchon (11) et la partie socle (6) sont positionnés automatiquement l'un par rapport à l'autre de telle sorte que les axes optiques (5, 12) de la lentille (10) et de la puce semi-conductrice (4) disposée sur le porteur de puce (3) coïncident au moins approximativement, et
- fixation durable du capuchon (11) à la partie socle (6).

2. Procédé selon la revendication 1, caractérisé en ce que le capuchon (11) formé de manière autonome et fabriqué en matière plastique est fabriqué comme composant séparé par une opération de moulage par injection.

3. Procédé selon la revendication 1 ou 2, caractérisé en ce que entre la partie socle (6) et le capuchon (11) un couvercle lenticulaire (16) recouvrant la puce semi-conducteur (4), est fabriqué.

4. Procédé selon l'une des revendications 1 à 3, caractérisé en ce que la séparation d'un composant semi-conducteur (1) optoélectronique unique de la bande porteuse de puces (22) n'intervient qu'après fabrication de la partie socle (6), fixation de la puce semi-conductrice (4) sur la surface porteuse de puces (2) par bonding, ainsi que mise en contact de la puce semi-conductrice (4) avec les raccords d'électrodes (7, 8).

5. Procédé selon l'une des revendications 1 à 4, caractérisé en ce que le capuchon (11) comporte un moyen de retenue (13) pour une liaison mécanique par conjugaison de formes avec un moyen de soutien (14) de la partie socle (6), de telle sorte que lors de la pose du capuchon (11) sur la partie socle (6) le moyen de retenue (13) et le moyen de soutien (14) engrènent l'un dans l'autre en alternance, et le moyen de retenue (13) et le moyen de soutien (14) sont formés de telle sorte qu'ils soient automatiquement positionnés l'un par rapport à l'autre lors de la pose du capuchon (11) sur la partie socle (6) de telle sorte que les axes optiques (12) de la lentille (10) et de la puce semi-conductrice (4) disposée sur le porteur de puce (3) coïncident au moins approximativement.

6. Procédé selon la revendication 5, caractérisé en ce que le capuchon (11) et la partie socle (6) comportent une forme transversale essentiellement cylindrosymétrique, dont les axes de symétrie s'étendent concentriquement l'un par rapport à l'autre et coïncident chacun avec les axes optiques (5, 12) de la lentille (10) et de la puce semi-conductrice (4).

7. Procédé selon la revendication 5 ou 6, caractérisé en ce que le moyen de retenue (13) du capuchon (11) et le moyen de soutien (14) de la partie socle (6) sont adaptés, resp. conformés pour réaliser une liaison par conjugaison de formes.

8. Procédé selon l'une des revendications 5 à 7, caractérisé en ce que le moyen de retenue (13) et le moyen de soutien (14) sont formés de telle sorte que lors de l'assemblage du capuchon (11) et de la partie socle (6) ceux-ci sont positionnés automatiquement les uns par rapport aux autres de telle sorte qu'une position symétrique stable au moins approximativement sans jeu du capuchon (11) et de la partie socle (6) est garantie.

9. Procédé selon l'une des revendications 5 à 8, caractérisé en ce que le moyen de soutien (14) de la partie socle (6) possède à sa périphérie extérieure une surface de butée (15) périphérique et soutenant le moyen de retenue (13) du capuchon (11).

10. Procédé selon l'une des revendications 5 à 9, caractérisé en ce que les moyens de retenue (13) et de soutien (14) associés à la liaison mécanique par conjugaison de formes détachables dans le sens axial du capuchon (11) et de la partie du socle (6) sont formés par des saillies (20) et évidements à rainures (21) circulaires aux deux pièces et conçus de manière à alterner.

11. Procédé selon l'une des revendications 5 à 10, caractérisé en ce que les moyens de retenue (13) et de soutien (14) prévus dans le sens circonférentiel pour une orientation opposée du capuchon (11) et de la partie du socle (6) sont formés par des saillies (20) et des évidements (21) supplémentaires radiaux disposés en alternance sur ces deux pièces et formés de manière limitée dans le sens circonférentiel.

12. Procédé selon l'une des revendications 5 à 11, caractérisé en ce que le moyen de retenue (13) du capuchon (11) est pourvu d'une saillie élastique (18), associée à un cran (19) prévu dans le moyen de soutien (14) de la partie socle (6) pour fixer automatiquement le capuchon (11) et la partie socle (6) dans une position de montage.

13. Procédé selon l'une des revendications 1 à 12, caractérisé en ce que la partie socle (6) est fabriquée en matière plastique hautes températures.

14. Procédé selon l'une des revendications 1 à 13, caractérisé en ce que la partie socle (6) est fabriquée en polymère thermoplastique, notamment en polymère à cristaux liquides, en polyphtalamide ou en polysulfone.

15. Procédé selon la revendication 3, caractérisé en ce que le couvercle lenticulaire (16) recouvrant la puce semi-conductrice (4) est fabriqué en un matériau en matière plastique transparente, qui comporte notamment un matériau filtrant optique.

16. Procédé selon l'une des revendications 1 à 15, caractérisé en ce que la partie socle (6) fabriquée en matière plastique comporte un matériau destiné à augmenter l'absorption de la lumière diffusée incidente, et qu'elle est notamment colorée en noir.

17. Procédé selon l'une des revendications 1 à 16, caractérisé en ce que un réflecteur (17) associé à la puce semi-conductrice (4) est prévu à l'intérieur de la partie socle (6).
